# EUROPEAN PATENT APPLICATION

(11) **EP 2 679 650 A1**
(43) Date of publication of application: **01.01.2014**
(21) Application number: 11853024.5
(22) Date of filing: 22.12.2011
(51) Int. Cl.: C09J 175/04, C08G 18/42, C08G 18/62, C09J 11/06, C09J 175/06, H01L 31/042

(54) **OUTDOOR URETHANE ADHESIVE AGENT**

(30) Priority: 28.12.2010 JP 2010292442
(71) Applicant: Henkel AG & Co. KGaA, 40589 Düsseldorf (DE)
(72) Inventor: MATSUKI, Yuichi, Minoo-shi Osaka 562-8586 (JP); YOSHIDA, Yoshio, Minoo-shi Osaka 562-8586 (JP); ITO, Shoko, Minoo-shi Osaka 562-8586 (JP)
(74) Representative: Peters, Frank M.
(86) International application number: PCT/JP2011/079810
(87) International publication number: WO 2012/090857

(57) **Abstract**

Provided are: an outdoor urethane adhesive agent which has excellent initial adhesion properties, exhibits excellent adhesion properties after being cured, can be cured into a coating film having excellent flexibility, and preferably has superior weather resistance; a solar cell back sheet which is produced using the adhesive agent; and a solar cell module which is produced using the solar cell back sheet. An outdoor urethane adhesive agent (A) comprising a urethane resin (A) produced by the reaction of an isocyanate compound (a1) with a polyol (a2) having an ester bond, wherein the isocyanate compound (a1) comprises at least one compound selected from aliphatic isocyanates and alicyclic isocyanates, and the polyol (a2) comprises both a polyester polyol (a2-1) and an acrylic polyol (a2-2). The adhesive agent has excellent initial adhesion properties, exhibits excellent adhesion properties after being cured, and can be cured into a coating film. having excellent flexibility. When the adhesive agent additionally contains a hydroxyphenyltriazine-type compound, the adhesive agent can rarely undergo the change in color and can have superior weather resistance.

## Description

### Technical Field

The present invention relates to an outdoor urethane adhesive. More particularly, the present invention relates to a solar battery backsheet obtainable by using the adhesive, and a solar battery module obtainable by using the solar battery backsheet.

### Background Art

Outdoor materials such as barrier materials, roof materials, solar battery panel materials, window materials, outdoor flooring materials, illumination protective materials, automobile members and signboards include, as a constituent material, a laminate obtainable by laminating plural films using an adhesive. Examples of the films constituting the laminate include metal foils, metal plates and deposited metal films of aluminum, copper, steel and the like; plastic films of polypropylene, polyvinyl chloride, polyester, fluorine resin, acrylic resin and the like; and so on.

Since these laminates are exposed outdoors over a long period of time, excellent durability is required of an outdoor adhesive. A higher level of durability than that of a conventional outdoor adhesive is especially required of an adhesive for a solar battery which converts sunlight into electric power.

The practical use of solar batteries as useful energy resources has made progress. Such solar batteries include various types, and silicon-based solar batteries, compound-based solar batteries, organic solar batteries and the like are known as typical solar batteries.

In these solar batteries, a surface protective sheet is commonly provided on the surface on which sunlight falls for the purpose of protecting the surface. A rear protective sheet (backsheet) is also provided on the surface opposite to the surface on which sunlight falls for the purpose of protecting a solar battery cell.

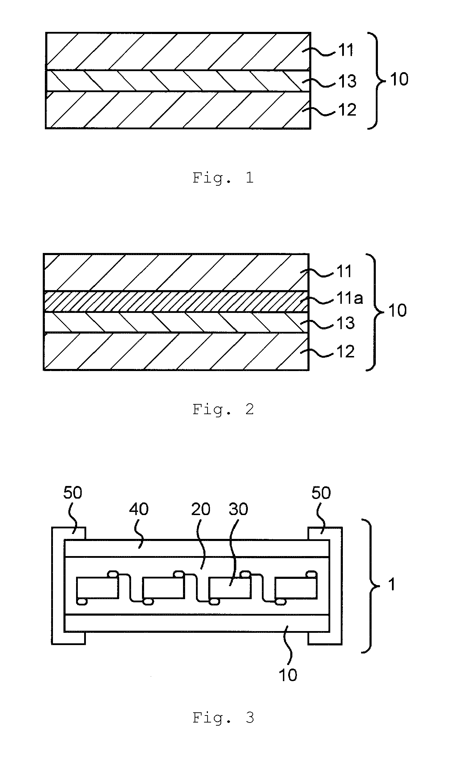

As shown in Fig. 1, a backsheet 10 is a laminate of plural films 11 and 12, and the films 11 and 12 are laminated (or pasted) by interposing an adhesive 13 therebetween. The backsheet 10 constitutes a solar battery module 1, together with a sealing material 20, a solar battery cell 30 and a glass plate 40 (see Fig. 3).

Since the solar battery module 1 is exposed outdoors over a long period, sufficient durability against high temperature, high humidity and sunlight is required. Particularly, when the adhesive 13 shows poor performance, the films 11 and 12 are peeled and thus the appearance of the laminated backsheet 10 is impaired. Therefore, it is required that the adhesive for solar battery backsheet does not result in peeling of the film even if exposed outdoors over a long period.

Patent Documents 1 to 3 disclose the use of a urethane-based adhesive, as an exemplary adhesive for solar battery backsheet, in the production of a solar battery backsheet.
Patent Document 1 discloses a urethane-based adhesive for solar battery backsheets that is produced by reacting various polyols such as polyester polyol, acrylic polyol and polycarbonate polyol with an isocyanate compound (see [0055] and [0056] of Patent Document 1).

Patent Document 2 discloses an outdoor urethane-based adhesive with durability improved by using a specific polyester polyol (see CLAIMS, [0014], etc. of Patent Document 2). The Patent Document discloses that the hydrolysis resistance of a urethane adhesive is improved by using the specific polyester polyol as an adhesive raw material; the obtained adhesive is effective for use in the solar battery backsheet (see [0070] to [0072] of Patent Document 2).
Patent Document 3 discloses the mixing of an isocyanate curing agent with an acrylic polyol to produce an adhesive (see Table 1 and Table 2 of Patent Document 3); a solar battery backsheet is produced using said adhesive (see [0107] of Patent Document 3).

Patent Documents 1 to 3 teach that poor appearance of the solar battery module can be prevented by producing a solar battery backsheet using an adhesive having excellent hydrolysis resistance and laminate strength. However, the level of durability required of the adhesive for solar battery backsheet is increasing year by year. It is considered that the adhesives of Patent Documents 1 to 3 do not satisfy the present remarkably high level of performance requirements for initial adhesion, adhesion after curing and flexibility of a film (or coat) of the adhesive after curing. When the solar battery backsheet is produced by using these adhesives, plural films constituting the backsheet may be peeled off when exposed to a severe outdoor environment.

Furthermore, progress has recently been made in the development of an organic solar battery with lower production costs as compared to solar batteries using silicon and an inorganic compound material. Since the organic solar battery has the property that it can be colored and can also have flexibility, a transparent film may be employed as a film constituting a solar battery backsheet. Therefore, it is required for the adhesive for solar battery backsheet to maintain peel strength over a long period, to cause little change in color difference even when exposed to ultraviolet rays over a long period and to have conspicuously excellent weatherability.

### Prior Art Document

### Patent Document

Patent Document 1: JP2008-004691A
Patent Document 2: JP4416047B
Patent Document 3: JP2010-263193A

### Disclosure of the Invention

### Problems to be Solved by the Invention

The present invention has been made so as to solve these problems and an object thereof is to provide an outdoor urethane adhesive which is excellent in initial adhesion, adhesion after curing and flexibility of a film (or coat) of the adhesive after curing, and preferably more excellent in weatherability; a solar battery backsheet obtainable by using the adhesive; and a solar battery module obtainable by using the solar battery backsheet.

### Means for Solving the Problems

The present inventors have intensively studied and found, surprisingly, that it is possible to obtain an adhesive for solar battery backsheet in which excellent initial adhesion, adhesion after curing and flexibility of a film (or coat) of the adhesive after curing are achieved by using a specific polyol and a specific isocyanate compound as raw materials of a urethane resin, and also weatherability is remarkably improved by adding a specific ultraviolet absorber, and thus the present invention has been completed.

Namely, the present invention provides, in a first aspect, an outdoor urethane adhesive, including:
a urethane resin (A) obtainable by the reaction of an isocyanate compound (a1) with a polyol having an ester bond (a2), wherein
the isocyanate compound (a1) contains at least one selected from an aliphatic isocyanate and an alicyclic isocyanate, and
the polyol (a2) contains both a polyester polyol (a2-1) and an acrylic polyol (a2-2).

The present invention provides, in an embodiment, an outdoor urethane adhesive, wherein an alkyl group having 4 or more carbon atoms in total is bound to an ester bond in the acrylic polyol (a2-2).
The present invention provides, in another embodiment, an outdoor urethane adhesive, wherein the polyester polyol (a2-1) is obtained by the polycondensation of a dicarboxylic acid with a polyhydric alcohol,
the polyhydric alcohol contains a branched aliphatic diol, and a branched side chain in one molecule of the branched aliphatic diol contains two or more carbon atoms in total.

The present invention provides, in a preferred embodiment, the outdoor urethane adhesive, wherein the above-mentioned branched aliphatic diol is at least one selected from 2-butyl-2-ethyl-1,3-propanediol and 2,4-diethyl-1,5-pentanediol.
The present invention provides, in a further preferred embodiment, an outdoor urethane adhesive further including a hydroxyphenyltriazine-based compound (B).

The present invention provides, in another aspect, a solar battery backsheet obtainable by using the outdoor urethane adhesive.
The present invention provides, in a preferred aspect, a solar battery module obtainable by using the solar battery backsheet.

### Effects of the Invention

The outdoor urethane adhesive according to the present invention includes a urethane resin (A) obtainable by the reaction of an isocyanate compound (a1) with a polyol (a2) having an ester bond, wherein
the isocyanate compound (a1) contains at least one selected from an aliphatic isocyanate and an alicyclic isocyanate, and
the polyol (a2) contains both a polyester polyol (a2-1) and an acrylic polyol (a2-2), whereby, the outdoor urethane adhesive has improved initial adhesion, adhesion after curing and flexibility of a film (or coat) of the adhesive after curing and is also excellent in these characteristics, and thus the adhesive is suited for use as an adhesive for solar battery backsheet.

The outdoor urethane adhesive of the present invention is improved in shear creep in initial adhesion performance and is less likely to cause appearance of tack in a pressure cooker test in cured film (or coat) characteristics of the adhesive when an alkyl group having 4 or more carbon atoms in total is connected to an ester bond in the acrylic polyol (a2-2).
The outdoor urethane adhesive according to the present invention is excellent in tack of initial adhesion and is also excellent in flexibility in characteristics of a cured film of the adhesive when the polyester polyol (a2-1) is obtained by the polycondensation of a dicarboxylic acid with a polyhydric alcohol, the polyhydric alcohol contains a branched aliphatic diol, and a branched side chain in one molecule of the branched aliphatic diol contains two or more carbon atoms in total.

The outdoor urethane adhesive of the present invention is excellent in tack in initial adhesion and is excellent in flexibility of a cured film of the adhesive, and is more suited for use in a solar battery backsheet when the branched aliphatic diol is at least one selected from 2-butyl-2-ethyl-1,3-propanediol and 2,4-diethyl-1,5-pentanediol.
The outdoor urethane adhesive of the present invention causes little change in color difference and exhibits improved weatherability and is therefore more suited for use as an adhesive for solar battery backsheet when it further includes a hydroxyphenyltriazine-based compound.

Since the solar battery backsheet according to the present invention is obtained by using the above adhesive for solar battery backsheet, it is possible to prevent films constituting the backsheet from peeling as a result of degradation of the adhesive, and to prevent discoloration of the films even if exposed outsides for a long period.
An organic solar battery using an organic compound in a light absorption layer has recently been developed, and it is required for the organic solar battery to have colorability and flexibility. Therefore, since a film constituting the backsheet of the organic solar battery may become transparent, the solar battery backsheet of the present invention, which causes little change in color difference and flexibility, is useful from such a point of view.
Since the solar battery module according to the present invention is obtained by using the solar battery backsheet, it is excellent in appearance and is also excellent in durability.

### Brief Description of the Drawings

Fig. 1 is a sectional view showing an embodiment of a solar battery backsheet of the present invention.
Fig. 2 is a sectional view showing another embodiment of a solar battery backsheet of the present invention.
Fig. 3 is a sectional view showing an embodiment of a solar battery module of the present invention.

### Embodiments for Carrying Out the Invention

The adhesive for solar battery backsheet according to the present invention contains a urethane resin (A) obtainable by the reaction of a specific acrylic polyol (a1) with a specific isocyanate compound (a2).
The isocyanate compound (a1) contains at least one selected from an aliphatic isocyanate and an alicyclic isocyanate. In the present invention, it is particularly preferable to contain the aliphatic isocyanate.

The "isocyanate compound (a1)" according to the present invention does not mean that it is composed of only the aliphatic isocyanate and the alicyclic isocyanate. As long as the objective outdoor urethane adhesive of the present invention is obtained, in other words, as long as an adverse influence is not exerted on adhesion and weatherability of the outdoor urethane adhesive of the present invention, the isocyanate compound (a1) may contain an aromatic isocyanate. The isocyanate compound (a1) preferably contains no ethylenic double bond (for example, ethylene group, butylene group, etc.) from the viewpoint of weatherability.

In the present specification, as mentioned above, the isocyanate is classified into an aliphatic isocyanate, an alicyclic isocyanate and an aromatic isocyanate. The isocyanate compound (a1) as a feature of the present invention is not composed of only the aromatic isocyanate since it contains at least one selected from the aliphatic isocyanate and the alicyclic isocyanate.

In the present specification, the "aliphatic isocyanate" refers to a compound which has a chain-like hydrocarbon chain in which the isocyanate group is directly connected to the hydrocarbon chain, and also has no cyclic hydrocarbon chain. Although the "aliphatic isocyanate" may have an aromatic ring, the aromatic ring is not directly connected to the isocyanate group.
In the present specification, the aromatic ring is not contained in the cyclic hydrocarbon chain.

The "alicyclic isocyanate" is a compound which has a cyclic hydrocarbon chain and may have a chain-like hydrocarbon chain. The isocyanate group may be either directly connected to the cyclic hydrocarbon chain, or may be directly connected to the chain-like hydrocarbon chain which may be present. Although the "alicyclic isocyanate" may have an aromatic ring, the aromatic ring is not directly connected to the isocyanate group.

The "aromatic isocyanate" refers to a compound which has an aromatic ring, in which the isocyanate group is directly connected to the aromatic ring. Therefore, a compound, in which the isocyanate group is not directly connected to the aromatic ring, is classified into the aliphatic isocyanate or the alicyclic isocyanate even if it contains the aromatic ring in the molecule.

Therefore, for example, 4,4'-diphenylmethane diisocyanate (OCN-C₆H₄-CH₂-C₆H₄-NCO) corresponds to the aromatic isocyanate since the isocyanate groups are directly connected to the aromatic ring. On the other hand, for example, xylylene diisocyanate (OCN-CH₂-C₆H₄-CH₂-NCO) corresponds to the aliphatic isocyanate since it has an aromatic ring, but the isocyanate groups are not directly connected to the aromatic ring but connected to methylene groups.
The aromatic ring may be fused with two or more benzene rings.

Examples of the aliphatic isocyanate include 1,4-diisocyanatobutane, 1,5-diisocyanatopentane, 1,6-diisocyanatohexane (hereinafter referred to as HDI), 1,6-diisocyanato-2,2,4-trimethylhexane, methyl 2,6-diisocyanatohexanoate (lysine diisocyanate), 1,3-bis(isocyanatomethyl)benzene (xylylene diisocyanate) and the like.

Examples of the alicyclic isocyanate include 5-isocyanato-1-isocyanatomethyl-1,3,3-trimethylcyclohexane (isophorone diisocyanate), 1,3-bis(isocyanatomethyl)cyclohexane (hydrogenated xylylene diisocyanate), bis(4-isocyanatocyclohexyl)methane (hydrogenated diphenylmethane diisocyanate), 1,4-diisocyanatocyclohexane and the like.

In the present invention, the isocyanate compound (a1) may contain the aromatic isocyanate as long as the objective urethane adhesive of the present invention can be obtained. Examples of the aromatic isocyanate include 4,4'-diphenylmethane diisocyanate, p-phenylenediisocyanate, m-phenylenediisocyanate and the like.
These isocyanate compounds can be used alone, or in combination. Particularly, HDI, isophorone diisocyanate and xylylene diisocyanate are preferable, and a trimer of HDI, a trimer of isophorone diisocyanate and a monomer of xylylene diisocyanate are particularly preferable.

In the present invention, the polyol (a2) having an ester bond contains both a polyester polyol and an acrylic polyol. The polyol (a2) having an ester bond preferably contain no ethylenic double bond from the viewpoint of weatherability.
In the present invention, the "polyester polyol" refers to a compound which is a "main-chain type" polyester and has an ester bond and a hydroxyl group in the "main chain". This hydroxyl group usually locates at the end of the main chain and serves as a functional group capable of reacting with the isocyanate group.

The polyester polyol is commonly obtained by the condensation polymerization reaction of a polyhydric alcohol with a dicarboxylic acid and an anhydride thereof.
Examples of such a dicarboxylic acid include oxalic acid, malonic acid, succinic acid, glutaric acid, adipic acid, pimelic acid, suberic acid, azelaic acid, sebacic acid, dodecanedioic acid, 2-methylsuccinic acid, 2-methyladipic acid, 3-methyladipic acid, 3-methylpentanedioic acid, 2-methyloctanedioic acid, 3,8-dimethyldecanedioic acid, 3,7-dimethyldecanedioic acid, phthalic acid, terephthalic acid, isophthalic acid, naphthalenedicarboxylic acid, trimellitic acid, trimesic acid, cyclohexanedicarboxylic acid and the like. These dicarboxylic acids are used alone or in combination.
Examples of the carboxylic anhydride include acetic anhydride, propionic anhydride, succinic anhydride, maleic anhydride and phthalic anhydride. These carboxylic anhydrides may be used alone, or a plurality of these anhydrides may be used in combination.

The polyhydric alcohol preferably has 1 to 3 functional groups, and particularly preferably contains so-called diol such as a difunctional diol.
Examples of the diol include linear aliphatic diols such as ethylene glycol, propylene glycol, butanediol, pentanediol, hexanediol, heptanediol, octanediol, nonanediol and decanediol;
branched aliphatic diols such as 2-butyl-2-ethyl-1,3-propanediol, 2,4-diethyl-1,5-pentanediol, 2,2-dimethyl-1,3-propanediol, 3,3-dimethyl-1,5-pentanediol, 2-methyl-2-ethyl-1,3-propanediol, 3-methyl-3-ethyl-1,5-pentanediol, 2-methyl-2-propyl-1,3-propanediol, 3-methyl-3-propyl-1,5-pentanediol, 2-methyl-2-butyl-1,3-propanediol, 3-methyl-3-butyl-1,5-pentanediol, 2,2-diethyl-1,3-propanediol, 3,3-diethyl-1,5-pentanediol, 2-ethyl-2-butyl-1,3-propanediol, 3-ethyl-3-butyl-1,5-pentanediol, 2-ethyl-2-propyl-1,3-propanediol, 3-ethyl-3-propyl-1,5-pentanediol, 2,2-dibutyl-1,3-propanediol, 3,3-dibutyl-1,5-pentanediol, 2,2-dipropyl-1,3-propanediol, 3,3-dipropyl-1,5-pentanediol, 2-butyl-2-propyl-1,3-propanediol, 3-butyl-3-propyl-1,5-pentanediol, 2-ethyl-1,3-propanediol, 2-propyl-1,3-propanediol, 2-butyl-1,3-propanediol, 3-ethyl-1,5-pentanediol, 3-propyl-1,5-pentanediol, 3-butyl-1,5-pentanediol, 3-octyl-1,5-pentanediol, 3-myristyl-1,5-pentanediol, 3-stearyl-1,5-pentanediol, 2-ethyl-1,6-hexanediol, 2-propyl-1,6-hexanediol, 2-butyl-1,6-hexanediol, 5-ethyl-1,9-nonanediol, 5-propyl-1,9-nonanediol and 5-butyl-1,9-nonanediol; and the like.

These diols can be used alone or in combination.
In the present invention, it is preferred that the polyhydric alcohol contains the branched aliphatic diol, and a branched side chain in one molecule of the branched aliphatic diol contains two or more carbon atoms in total.
The branched aliphatic diol, in which the branched side chain in one molecule contains two or more carbon atoms in total, is preferably at least one selected from 2-butyl-2-ethyl-1,3-propanediol and 2,4-diethyl-1,5-pentanediol.
The outdoor urethane adhesive of the present invention is more excellent in flexibility in characteristics of a cured film of the adhesive by using the above-mentioned branched aliphatic diol.

In the present invention, the "acrylic polyol" refers to a compound which is obtained by the addition polymerization reaction of a (meth)acrylate having a hydroxyl group, and has an ester bond in the "side chain".
The "acrylic polyol" may be either a homopolymer of a (meth)acrylate having a hydroxyl group, or a copolymer of the (meth)acrylate having a hydroxyl group with the "other polymerizable monomer". The hydroxyl group of the acrylic polyol reacts with the isocyanate group.

Examples of the "(meth)acrylate having a hydroxyl group" include 2-hydroxyethyl (meth)acrylate, 2-hydroxypropyl (meth)acrylate, 3-hydroxypropyl (meth)acrylate, glycerin mono(meth)acrylate, 4-hydroxybutyl acrylate and the like.

The "other polymerizable monomer" is a "radical polymerizable monomer having an ethylenic double bond" other than the "(meth)acrylate having a hydroxyl group". Specific examples thereof include (meth)acrylic acid, methyl (meth)acrylate, ethyl (meth)acrylate, butyl (meth)acrylate, cyclohexyl (meth)acrylate, 2-ethylhexyl (meth)acrylate, dicyclopentanyl (meth)acrylate, isobornyl (meth)acrylate, styrene and vinyltoluene and the like.

In the acrylic polyol, an alkyl group having 4 or more carbon atoms in total is preferably connected to the ester bond. In the present invention, the ester bond connected to the alkyl group having 4 or more carbon atoms preferably accounts for 50% or more of ester bonds of the acrylic polyol. When the ester bond connected to the alkyl group having 4 or more carbon atoms in total accounts for 50% or more, the outdoor urethane adhesive is excellent in shear creep in initial adhesion performances and is less likely to cause appearance of tack in a pressure cooker test in cured film characteristics of the adhesive.

The chemical structure of the alkyl group connected to the ester bond of the acrylic polyol is based on the "(meth)acrylate having a hydroxyl group" and the "other polymerizable monomer" serving as "raw monomers" of the acrylic polymer.
In the present invention, the monomer in which the alkyl group having 4 or more carbon atoms in total is connected to the ester bond is preferably contained in the amount of 50 parts by weight or more based on 100 parts by weight of the "raw monomers" of the acrylic polymer. When the amount of the monomer in which the alkyl group having 4 or more carbon atoms in total is connected to the ester bond is 50 parts by weight or more, the outdoor urethane adhesive is more excellent in shear creep in initial adhesion performances and is less likely to cause appearance of tack in a pressure cooker test in cured film characteristics of the adhesive.

As long as the objective outdoor urethane adhesive of the present invention can be obtained, the polyol (a2) having an ester bond may contain a polyether polyol. Examples of the polyether polyol include polyoxytetramethylene glycol (PTMG), polyoxypropylene glycol (PPG), polyoxyethylene glycol (PEG) and the like.

The urethane resin (A) according to the present invention can be obtained by the reaction of the isocyanate compound (a1) with the polyol having an ester bond (a2). In the reaction, a known method can be used and the reaction can be usually performed by mixing the isocyanate compound (a1) with the polyol having an ester bond (a2). There is no particular limitation on the mixing method as long as the urethane resin (A) according to the present invention can be obtained.

In the present description, a "hydroxyphenyltriazine-based compound (B)" is a compound which is a kind of a triazine derivative in which a hydroxyphenyl derivative is bound to carbon atoms of a triazine derivative, which is commonly referred to a hydroxyphenyltriazine-based compound. There is no particular limitation on the hydroxyphenyltriazine-based compound as long as the objective outdoor urethane adhesive of the present invention can be obtained.

Examples of such a hydroxyphenyltriazine-based compound (B) include, but are not limited to, compounds represented by the following formulas (1) to (5), and isomers thereof.

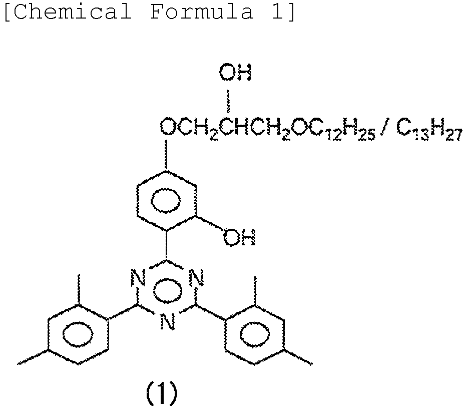

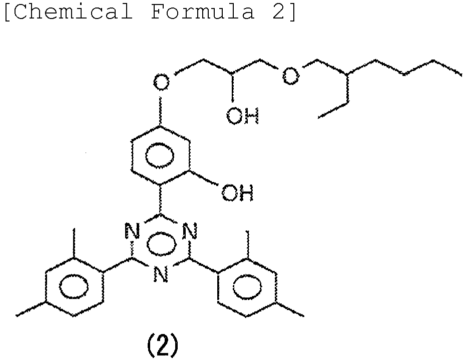

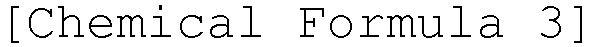

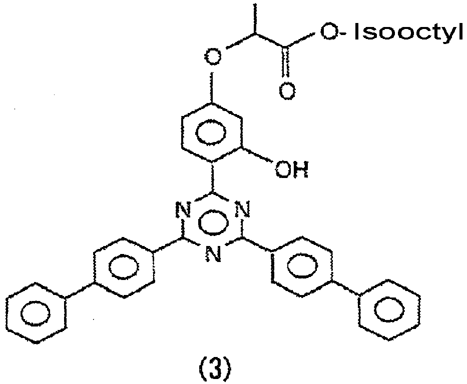

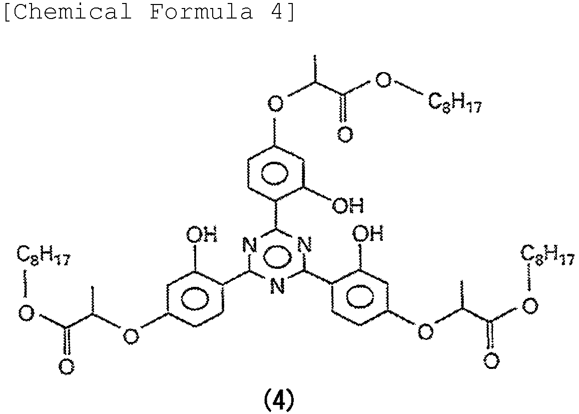

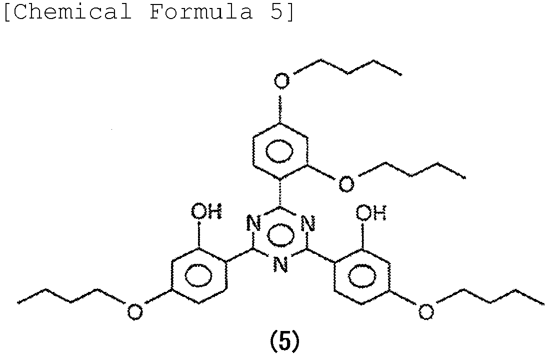

It is possible to use, as the hydroxyphenyltriazine-based compound (B), commercially available products. For example, TINUVIN 400, TINUVIN 405, TINUVIN 479, TINUVIN 477, TINUVIN 460 and the like (all of which are trade names) are commercially available from BASF Corp. Taking weatherability into consideration, TINUVIN 479 (trade name) is preferable. The hydroxyphenyltriazine-based compounds (B) can be used alone or in combination.
The hydroxyphenyltriazine-based compounds (B) of the chemical formulas (1) to (5) are commonly used as an ultraviolet absorber, and can be used in combination with other ultraviolet absorbers as long as the objective outdoor urethane adhesive of the present invention can be obtained. Examples of the "other ultraviolet absorber" include a benzotriazole-based compound, an anilide oxalate-based compound, a malonic acid ester-based compound and the like, and commercially available products can be used.

The outdoor urethane adhesive of the present invention preferably contains, in addition to the components (A) and (B), a silane compound (C).
In the present invention, it is possible to use, as the silane compound, for example, (meth)acryloxyalkyltrialkoxysilanes, (meth)acryloxyalkylalkylalkoxysilanes, vinyltrialkoxysilanes, vinylalkylalkoxysilanes, epoxysilanes, mercaptosilanes and isocyanuratesilanes. However, the silane compound is not limited to only these silane compounds.

Examples of the "(meth)acryloxyalkyltrialkoxysilanes" include 3-(meth)acryloxypropyltrimethoxysilane, 3-(meth)acryloxypropyltriethoxysilane, 4-(meth)acryloxyethyltrimethoxysilane and the like.
Examples of the "(meth)acryloxyalkylalkylalkoxysilanes" include 3-(meth)acryloxypropylmethyldimethoxysilane, 3-(meth)acryloxypropylmethyldiethoxysilane, 3-(meth)acryloxypropylethyldiethoxysilane, 3-(meth)acryloxyethylmethyldimethoxysilane and the like.

Examples of the "vinyltrialkoxysilanes" include vinyltrimethoxysilane, vinyltriethoxysilane, vinyldimethoxyethoxysilane, vinyltri(methoxyethoxy)silane, vinyltri(ethoxymethoxy)silane and the like.
Examples of the "vinylalkylalkoxysilanes" include vinylmethyldimethoxysilane, vinylethyldi(methoxyethoxy)silane, vinyldimethylmethoxysilane, vinyldiethyl(methoxyethoxy)silane and the like.

For example, the "epoxysilanes" can be classified into a glycidyl-based silane and an epoxycyclohexyl-based silane. The "glycidyl-based silanes" have a glycidoxy group, and specific examples thereof include 3-glycidoxypropylmethyldiisopropenoxysilane, 3-glycidoxypropyltrimethoxysilane, 3-glycidoxypropyltriethoxysilane, 3-glycidoxypropyldiethoxysilane and the like.
The "epoxycyclohexyl-based silanes" have a 3,4-epoxycyclohexyl group, and specific examples thereof include 2-(3,4-epoxycyclohexyl)ethyltrimethoxysilane, 2-(3,4-epoxycyclohexyl)ethyltriethoxysilane and the like.

Examples of the "mercaptosilanes" include 3-mercaptopropyltrimethoxysilane, 3-mercaptopropyltriethoxysilane and the like.
Examples of "isocyanuratesilanes" include tris(3-(trimethoxysilyl)propyl)isocyanurate and the like.
These silane compounds (C) enable, in addition to an improvement in peel strength, an improvement in weatherability of an adhesive containing hydroxyphenyltriazine (B). In the present invention, it is particularly preferred that properties of the outdoor urethane adhesive are remarkably improved by the addition of the epoxysilanes.

It is preferred that the outdoor urethane adhesive of the present invention further contains at least one selected from a hindered phenol-based compound (D) and a hindered amine-based compound (E).
The "hindered phenol-based compound (D)" is commonly called a hindered phenol-based compound, and there is no particular limitation as long as the objective outdoor urethane adhesive of the present invention can be obtained.

It is possible to use, as the hindered phenol-based compound (D), commercially available products. For example, it is possible to use, as the hindered phenol-based compound (D), IRGANOX 1010, IRGANOX 1035, IRGANOX 1076, IRGANOX 1135, IRGANOX 1330, IRGANOX 1520 and the like (all of which are trade names). The hindered phenol-based compound is added to the adhesive as an antioxidant, and may also be used in combination with a phosphite-based antioxidant, a thioether-based antioxidant, an amine-based antioxidant and the like.

The "hindered amine-based compound (E)" is commonly called a hindered amine-based compound, and there is no particular limitation as long as the objective outdoor urethane adhesive of the present invention can be obtained.
It is possible to use, as the hindered amine-based compound (E), commercially available products. For example, it is possible to use, as the hindered amine-based compound (E), TINUVIN 765, TINUVIN 111FDL, TINUVIN 123, TINUVIN 144, TINUVIN 152, TINUVIN 292, TINUVIN 5100 and the like (all of which are trade names). The hindered amine-based compound is added to the adhesive as a photostabilizer, and may also be used in combination with a benzotriazole-based photostabilizer, a benzoate-based photostabilizer and the like.

The outdoor urethane adhesive according to the present invention can further contain the other components as long as the objective outdoor urethane adhesive can be obtained.
There is no particular limitation on timing of the addition of the "other components" to the outdoor urethane adhesive as long as the objective outdoor urethane resin of the present invention can be obtained. For example, the other components may be added together with the isocyanate compound (a1) and the polyol (a2) in synthesizing the urethane resin (A), or may be added together in adding the hydroxyphenyltriazine-based compound (B) after synthesizing the urethane resin (A) by the reaction of the isocyanate compound (a1) with the polyol (a2).

Examples of the "other components" include a tackifier resin, a pigment, a plasticizer, a flame retardant, a catalyst, a wax and the like.
Examples of the "tackifier resin" include a styrene-based resin, a terpene-based resin, aliphatic petroleum resin, an aromatic petroleum resin, a rosin ester, an acrylic resin, a polyester resin (excluding polyester polyol) and the like.
Examples of the "pigment" include titanium oxide, carbon black and the like.

Examples of the "plasticizer" include dioctyl phthalate, dibutyl phthalate, diisononyl adipate, dioctyl adipate, mineral spirit and the like.
Examples of the "flame retardant" include a halogen-based flame retardant, a phosphorous-based flame retardant, an antimony-based flame retardant, a metal hydroxide-based flame retardant and the like.

Examples of the "catalyst" include metal catalysts such as tin catalysts (trimethyltin laurate, trimethyltin hydroxide, dibutyltin dilaurate, dibutyltin maleate, etc.), lead-based catalysts (lead oleate, lead naphthenate, lead octenate, etc.), and other metal catalysts (naphthenic acid metal salts such as cobalt naphthenate) and amine-based catalysts such as triethylenediamine, tetramethylethylenediamine, tetramethylhexylenediamine, diazabicycloalkenes, dialkylaminoalkylamines and the like.
The "wax" is preferably wax such as paraffin wax and microcrystalline wax.

The outdoor urethane adhesive of the present invention can be produced by mixing the above-mentioned components (A) and (B), and the optionally added components (C), (D) and (E) which are optionally added components, and the other components. There is no particular limitation on the mixing method as long as the objective outdoor urethane adhesive of the present invention can be obtained. There is also no particular limitation on the order of mixing the components. The outdoor urethane adhesive according to the present invention can be produced without requiring a special mixing method and a special mixing order. The obtained outdoor urethane adhesive is excellent in both adhesive strength and weatherability.

Therefore, the outdoor urethane adhesive is suited for outdoor materials such as barrier materials, roof materials, solar battery modules, window materials, outdoor flooring materials, illumination protective materials, automobile members and signboards. These outdoor materials include a laminate obtainable by laminating plural films. Examples of the films include a film (metal deposited film) in which metal is deposited on a plastic base material, and a film (plastic film) in which metal is not deposited.

It is required for an adhesive for producing a solar battery module among the outdoor urethane adhesives to have excellent strength and a high level of weatherability. The outdoor urethane adhesive of the present invention is excellent in both peel strength and weatherability, and thus the adhesive is suited for an adhesive for solar battery backsheet.

In case of producing a solar battery backsheet, the outdoor urethane adhesive of the present invention is applied to a film. Application can be performed by various methods such as gravure coating, wire bar coating, air knife coating, die coating, lip coating and comma coating methods. Plural films coated with the outdoor urethane adhesive of the present invention are laminated with each other to obtain the solar battery backsheet.

An embodiment of the solar battery backsheet of the present invention is shown in Figs. 1 to 3, but the present invention is not limited to these embodiments.
Fig. 1 is a sectional view of a solar battery backsheet of the present invention. A solar battery backsheet 10 is formed of two films and an outdoor urethane adhesive 13 interposed therebetween, and the two films 11 and 12 are laminated with each other by the outdoor urethane adhesive 13. The films 11 and 12 may be made of either the same or different material. In Fig. 1, the two films 11 and 12 are laminated with each other, but three or more films may be laminated with one another.

Another embodiment of a solar battery backsheet according to the present invention is shown in Fig. 2. In Fig. 2, a thin film 11a is formed between the film 11 and the outdoor urethane adhesive 13. For example, Fig. 2 shows an embodiment in which a metal thin film 11a is formed on a surface of a film 11 when the film 11 is a plastic film. The metal thin film 11a can be formed on the surface of the plastic film 11 by vapor deposition, and the solar battery backsheet of Fig. 2 can be obtained by laminating the film 11 - with the metal thin film 11a formed thereon - and the film 12 with each other by interposing the outdoor urethane adhesive 13 therebetween.

Examples of the metal to be deposited on the plastic film include aluminum, steel, copper and the like. It is possible to impart barrier properties to the plastic film by subjecting the film to vapor deposition. Silicon oxide or aluminum oxide is used as a vapor deposition material. The plastic film 11 as a base material may be either transparent, or white- or black-colored.

A plastic film made of polyvinyl chloride, polyester, a fluorine resin or an acrylic resin is used as the film 12. In order to impart heat resistance and weatherability as well as rigidity, insulating properties and the like, a polyethylene terephthalate film or a polybutylene terephthalate film is preferably used. The films 11 and 12 may be either transparent or colored.
The deposited thin film 11a of the film 11 and the film 12 are laminated with each other using the outdoor urethane adhesive 13 of the present invention, and the films 11 and 12 are often laminated with each other by a dry lamination method.

Fig. 3 shows a sectional view of an example of a solar battery module of the present invention. In Fig. 3, it is possible to obtain a solar battery module 1 of the present invention by overlaying a glass plate 40, a sealing material 20 such as an ethylene-vinyl acetate resin (EVA), plural solar battery cells 30 which are commonly connected to each other to generate a desired voltage, and a backsheet 10 one another, and then fixing these members 10, 20, 30 and 40 using a spacer 50.

As mentioned above, since the backsheet 10 is a laminate of the plural films 11 and 12, it is required for the urethane adhesive 13 to cause no peeling of the films 11 and 12 even if the backsheet 10 is exposed outdoors over a long period.
The solar battery cell 30 is often produced by using silicon, and is sometimes produced by using an organic resin containing a dye. In that case, the solar battery module 1 becomes an organic-based (dye-sensitization) solar battery module. Since colorability is required of the organic-based (dye-sensitization) solar battery, a transparent film is often used as the films 11 and 12 which constitute the solar battery backsheet 10. Therefore, it is required for the outdoor urethane adhesive 13 to cause very little change in color difference even if exposed outdoors over a long period, and to have excellent weatherability.

Main embodiments of the present invention will be shown below.
1. An outdoor urethane adhesive, including:
   a urethane resin (A) obtainable by the reaction of an isocyanate compound (a1) with a polyol having an ester bond (a2), wherein
   the isocyanate compound (a1) contains at least one selected from an aliphatic isocyanate and an alicyclic isocyanate, and
   the polyol (a2) contains both a polyester polyol (a2-1) and an acrylic polyol (a2-2).
2. The outdoor urethane adhesive according to the above 1, wherein an alkyl group having 4 or more carbon atoms in total is connected to an ester bond in the acrylic polyol (a2-2).
3. The outdoor urethane adhesive according to the above 1 or 2, wherein the polyester polyol (a2-1) is obtained by the polycondensation of a dicarboxylic acid with a polyhydric alcohol,
   the polyhydric alcohol contains a branched aliphatic diol, and
   a branched side chain in one molecule of the branched aliphatic diol contains two or more carbon atoms in total.
4. The outdoor urethane adhesive according to the above 3, wherein the branched aliphatic diol is at least one selected from 2-butyl-2-ethyl-1,3-propanediol and 2,4-diethyl-1,5-pentanediol.
5. The outdoor urethane adhesive according to any one of the above 1 to 4, further including a hydroxyphenyltriazine-based compound (B).
6. A solar battery backsheet obtainable by using the outdoor urethane adhesive according to any one of the above 1 to 5.
7. A solar battery module obtainable by using the solar battery backsheet according to the above 6.

### Examples

The present invention will be described below by way of Examples and Comparative Examples, and these Examples are merely for illustrative purposes and are not meant to be limiting on the present invention.
Raw materials for outdoor urethane adhesives used in Examples and Comparative Examples are shown below.

(a1) Aliphatic isocyanate and alicyclic isocyanate
(a1-1) Aliphatic isocyanate: trimer (isocyanurate) of 1,6-diisocyanatohexane (HDI) <manufactured by Sumika Bayer Urethane Co., Ltd. under the trade name of SUMIDULE N3300, NCO% = 21.8%>
(a1-2) Aliphatic isocyanate: xylylene diisocyanate (XDI) <manufactured by Mitsui Chemicals, Inc. under the trade name of TAKENATE 500, NCO% = 44.7%>
(a1-3) Aliphatic isocyanate: TMP adduct of xylylene diisocyanate (XDI) <manufactured by Mitsui Chemicals, Inc. under the trade name of TAKENATE D-110N, solid content of (non-volatile component: 75%), NCO% = 15.7% (as the solid content) >
   Note) Numerical values in tables are values as the solid contents.
(a1-4) Alicyclic isocyanate: trimer (isocyanurate) of isophorone diisocyanate (IPDI) <manufactured by Evonik Degussa Corporation under the trade name of VESTANAT T1890/100, NCO% = 17.3%>

(a1') Aromatic isocyanate
(a1'-1) Polymeric MDI: manufactured by Sumika Bayer Urethane Co., Ltd. under the trade name of SUMIDULE 44V-10, NCO% = 31.0%)

(a2) Polyol having an ester bond
(a2-1) Polyester polyol
(a2-1-1) <Polyester polyol obtained by using 2-butyl-2-ethyl-1,3-propanediol as polyhydric alcohol>
A polyester polyol obtained by synthesizing by the following procedure was used.
In a four-necked flask equipped with a stirrer, a thermometer, a nitrogen introducing tube and a condenser tube, 201 g of isophthalic acid (manufactured by Wako Pure Chemical Industries, Ltd.), 100.1 g of phthalic anhydride (manufactured by Wako Pure Chemical Industries, Ltd.), 250 g of sebacic acid (manufactured by Wako Pure Chemical Industries, Ltd.), 39.5 g of polycaprolactonepolyol (product name of Capa 2043, manufactured by Perstorp Corp.), 601.1 g of 2-butyl-2-ethyl-1,3-propanediol (manufactured by Perstorp Corp.) and 8.21 g of trimethylolpropane (manufactured by Wako Pure Chemical Industries, Ltd.) were charged. After raising the temperature to 130°C, 0.2 g of titanium tetraisopropoxide (manufactured by Wako Pure Chemical Industries, Ltd.) was added, followed by temperature rise, dehydration and further reaction under reduced pressure at 220°C to obtain a desired polyester polyol.

(a2-1-2) <Polyester polyol obtained by using 2,4-dibutyl-1,5-pentanediol as a polyhydric alcohol>
HS 2N-226P (trade name) manufactured by HOKOKU Co., Ltd.: a polyester polyol composed of phthalic anhydride and 2,4-dibutyl-1,5-pentanediol

(a2-2) Acrylic polyol
(a2-2-1) Isocryl H270 (trade name) manufactured by Estron Chemical Inc.: an acrylic polyol obtained from methyl methacrylate, butyl acrylate, butyl methacrylate and 2-hydroxyethyl methacrylate in which the total content of butyl acrylate and butyl methacrylate (the number of carbon atoms of an alkyl group connected to an ester bond is 4) is 70% by weight

(a2-2-2) Acrylic polyol obtained by using butyl acrylate, cyclohexyl methacrylate and butyl methacrylate (the number of carbon atoms of an alkyl group connected to an ester bond is 4) in which the total content of these monomers is 82% by weight based on the entire monomer
An acrylic polyol obtained by synthesizing by the following procedure was used.
In a four-necked flask equipped with a stirring blade, a thermometer and a reflux condenser tube, 150 g of ethyl acetate (manufactured by Wako Pure Chemical Industries, Ltd.) was charged and refluxed at about 80°C. In the flask, 1 g of 2,2-azobisisobutyronitrile as a polymerization initiator was added and a mixture of monomers in each amount shown in Table 1 was continuously added dropwise over 1 hour and 30 minutes. After heating for 2 hours, a solution of an acrylic polyol (a2-2-2) having a non-volatile content of 32.2% by weight was obtained.
Methyl methacrylate (MMA); manufactured by Wako Pure Chemical Industries, Ltd., 10 g
Butyl acrylate(BA); manufactured by Wako Pure Chemical Industries, Ltd., 20 g
Cyclohexyl methacrylate (CHMA); manufactured by Wako Pure Chemical Industries, Ltd., 40 g
Butyl methacrylate (BA); manufactured by Wako Pure Chemical Industries, Ltd., 22 g
Glycidyl methacrylate (GMA); manufactured by Wako Pure Chemical Industries, Ltd., 2 g
2-hydroxyethyl methacrylate (HEMA); manufactured by Wako Pure Chemical Industries, Ltd., 6 g
Note) Numerical values in tables are values as the solid contents.

(a2-2-3) OG3 (trade name) manufactured by Soken Chemical & Engineering Co., Ltd. solid content: an acrylic polyol obtainable from n-butyl methacrylate, isobutyl methacrylate, methyl methacrylate and 2-hydroxyethyl methacrylate in which the total content of n-butyl methacrylate and isobutyl methacrylate (the number of carbon atoms of an alkyl group connected to an ester bond is 4) is 90% by weight (non-volatile content: 75%)
   Note) Numerical values in tables are values as the solid contents.

The urethane resin (A) according to the present invention is obtained by the reaction of the component (a1) with the component (a2).

(B) Hydroxyphenyltriazine-based compound
(B-1) TINUVIN 479 (trade name) manufactured by BASF Corp.: 2-[4-(octyl-2-methylethanoate)oxy-2-hydroxyphenyl]-4,6-[bis(2,4-dimethylphenyl)]-1,3,5-triazine

(B') Other ultraviolet absorbers
(B'-1) TINUVIN 234 (trade name) manufactured by BASF Corp.: 2-[2-hydroxy-3,5-bis(α,α-dimethylbenzyl)phenyl]-2H-benzotriazole

(C) Silane compound
(C-1) Sila-Ace S530 (trade name) manufactured by Chisso Corporation: 2-(3,4-epoxycyclohexyl)ethyltrimethoxysilane

(D) Hindered phenol-based compound
(D-1) IRGANOX 1330 (trade name) manufactured by BASF Corp.: 1,3,5-trimethyl-2,4,6-tris(3,5-di-t-butyl-4-hydroxybenzyl)benzene

(E) Hindered amine-based compound
(E-1) TINUVIN 765 (trade name) manufactured by BASF Corp.: sebacic acid bis(1,2,2,6,6-pentamethyl-4-piperidyl

The following outdoor urethane adhesives of Examples 1 to 9 and Comparative Examples 1 to 6 were produced by using the above-mentioned components and then performances of the obtained outdoor urethane adhesives were evaluated. The production methods and evaluation methods are shown below.

### Example 1

### <Production of Outdoor Urethane Adhesive>

As shown in Table 1, after weighing and mixing:
(a1-1) SUMIDULE N3300 (trade name) manufactured by Sumika Bayer Urethane Co., Ltd. (8.23 g),
(a2-1-1) the polyester polyol (22.38 g),
(B'-1) TINUVIN 234 (trade name) manufactured by BASF Corp. (1.46 g),
(C-1) Sila-Ace S530 (trade name) manufactured by Chisso Corporation (0.68 g),
(D-1) IRGANOX 1330 (trade name) manufactured by BASF Corp. (0.19 g), and
(E-1) TINUVIN 765 (trade name) manufactured by BASF Corp. (0.19 g), ethyl acetate was added to the mixture to prepare a solution having a solid content of 30%. The solution thus prepared was used as an outdoor urethane adhesive and the following tests were carried out.

### «Production of Samples for Confirmation of Initial (Before Curing) Adhesion Performances»

### <Production of Samples for Confirmation of Initial Adhesion>

The outdoor urethane adhesive of Example 1 was applied to a transparent polyethylene terephthalate (PET) sheet (manufactured by Mitsubishi Polyester Film Corporation under the trade name of 0300EW36) so that the weight of the solid component becomes 10 g/m², and then dried at 80°C for 10 minutes to obtain samples for confirmation of initial adhesion.

### <Production of Samples for Confirmation of Shear Creep Resistance>

First, the outdoor urethane adhesive of Example 1 was applied to a transparent polyethylene terephthalate (PET) sheet (manufactured by Mitsubishi Polyester Film Corporation under the trade name of 0300EW36) so that the weight of the solid component becomes 10 g/m², and then dried at 80°C for 10 minutes.
Then, a surface-treated transparent polyolefin film (linear low-density polyethylene film manufactured by Futamura Chemical Co., Ltd. under the trade name of LL-XUMN #30) was laid on the adhesive-coated surface of the PET sheet, and then both the films were pressed using a planar press machine (manufactured by SHINTO Metal Industries Corporation under the trade name of ASF-5) under a pressing pressure of 1.0 MPa at 50°C for 30 minutes. Thereafter, the obtained film laminate was cut into pieces measuring 15 mm in width and 95 mm in length to obtain samples for confirmation of shear creep resistance.

### «Production of Samples for Confirmation of Adhesion Performances after Curing and Samples for Confirmation of Degree of Yellowness»

First, the outdoor urethane adhesive of Example 1 was applied to a transparent polyethylene terephthalate (PET) sheet (manufactured by Mitsubishi Polyester Film Corporation under the trade name of 0300EW36) so that the weight of the solid component becomes 10 g/m², and then dried at 80°C for 10 minutes.
Then, a surface-treated transparent polyolefin film (linear low-density polyethylene film manufactured by Futamura Chemical Co., Ltd. under the trade name of LL-XUMN #30) was laid on the adhesive-coated surface of the PET sheet, and then both the films were pressed using the planar press machine (manufactured by SHINTO Metal Industries Corporation under the trade name of ASF-5) under a pressing pressure of 1.0 MPa at 50°C for 30 minutes. Thereafter, the obtained film laminate was aged at 40°C for one week and then cut into pieces measuring 15 mm in width to obtain samples for confirmation of adhesion performances after curing, while the obtained film laminate was cut into pieces measuring 25 mm square to obtain samples for confirmation of degree of yellowness.

### «Production of Samples for Confirmation of Characteristics of Cured Film»

The outdoor urethane adhesive of Example 1 was poured in a thickness of 3.3 mm into a cup made of polyethylene. After curing at room temperature for one day as it is and curing at 40°C for one week, a 1 mm thick cured film of the adhesive was obtained. The cured film was then cut into pieces measuring 5 mm in width and 30 mm in length to obtain samples for confirmation of characteristics of cured film of the adhesive.

### <Evaluation>

The outdoor urethane adhesive was evaluated by the following methods.

### «Initial (Before Curing) Adhesion Performances»

### <Initial Adhesion>

The degree of initial adhesion was confirmed by touching the coated surface of each sample for confirmation of initial adhesion with fingers.
A: Sufficient tack is recognized (satisfactory initial adhesion).
B: Ordinary tack is recognized (satisfactory initial adhesion).
D: Tack is scarcely recognized (poor initial adhesion).

### <Shear Creep Resistance>

A weight (30 g) was suspended on the surface-treated transparent polyolefin film side of each sample for confirmation of shear creep resistance and, after being left to stand at room temperature for 20 hours, slippage of the polyolefin film was measured.
A: Slippage is less than 4 mm.
B: Slippage is 4 mm or more but less than 8 mm.
D: Slippage is 8 mm or more.

### «Adhesion Performances after Curing»

Using a tensile strength testing machine (manufactured by ORIENTEC Co., Ltd. under the trade name of TENSILON RTM-250), the above film laminate (15 mm width) was subjected to a 180° peel test under a room temperature environment at a testing rate of 100 mm/min. Evaluation criteria are as follows.
A: Peel strength is 9 N/15 mm or more.
B: Peel strength is 6 N/15 mm or more but less than 9 N/15 mm.
D: Peel strength is less than 6 N/15 mm.

### «Characteristics of Cured Film»

### <Flexibility>

Each sample for confirmation of characteristics of the above-mentioned cured film was bent in a state where ends of a major axis side are overlapped each other, and then flexibility was confirmed.
B: Not broken
D: Broken

### <Surface Tack Appearance Time in PCT (Pressure Cooker Test) >

Each sample for confirmation of characteristics of the above-mentioned cured film was placed in a pressure cooker tester (manufactured by Yamato Scientific Co., Ltd. under the trade name of autoclave SP300 (trade name)). After being left to stand under a pressurized environment at 120°C and 0.1 MPa for 300 hours, presence or absence of tack of the adhesive cured film surface was confirmed.
A: No tack appears.
B: Very slight tack appears.
D: Severe tack appears.

### «Degree of Yellowing»

The above film laminate (25 mm square) was set to a UV irradiation tester (manufactured by IWASAKI ELECTRIC CO., LTD. under the trade name of EYE Super UV Tester W13) so that the polyolefin film side corresponds to a surface to be irradiated, and then irradiation was carried out under the conditions of an illuminance of 1,000 W/m² at 60°C and 50%RH for 15 hours. Using a color difference meter, a color difference (Δb) before and after irradiation was measured and the degree of yellowing was evaluated. Evaluation criteria are as follows.
A: Δb is less than 10.
B: Δb is 10 or more but less than 15.
D: Δb is 15 or more.

With respect to Examples 2 to 9 and Comparative Examples 1 to 6, the respective components were blended according to the formulations shown in Tables 1 to 4 to produce adhesives in the same manner as in Example 1. The production of film laminates 1 and 2 and the evaluation were carried out in the same manner as in Example 1.

**Table 1**

| | | | Example 1 | Example 2 | Example 3 | Example 4 | Example 5 |
|---|---|---|---|---|---|---|---|
| A | a1 | a1-1 | 8.23 | 8.27 | 5.58 | | |
| | | a1-2 | | | 5.58 | | |
| | | a1-3 | | | | 16.60 | 13.57 |
| | | a1-4 | | | | | |
| | a1' | a1'-1 | | | | | |
| | a2-1 | a2-1-1 | 22.38 | 22.50 | 21.76 | 40.72 | 21.16 |
| | | a2-1-2 | | | | | |
| | a2-2 | a2-2-1 | | | | | |
| | | a2-2-2 | 66.85 | 67.19 | 64.99 | 40.63 | 63.21 |
| | | a2-2-3 | | | | | |
| B | | B-1 | | 0.98 | 1.00 | 0.98 | 0.98 |
| B' | | B'-1 | 1.46 | | | | |
| C | | C-1 | 0.68 | 0.68 | 0.70 | 0.68 | 0.69 |
| D | | D-1 | 0.19 | 0.20 | 0.20 | 0.20 | 0.19 |
| E | | E-1 | 0.19 | 0.20 | 0.20 | 0.20 | 0.20 |
| Total | | | 100.00 | 100.00 | 100.00 | 100.00 | 100.00 |
| Initial (before curing) adhesion performances | | Initial adhesion | B | B | B | A | B |
| | | Shear creep resistance | A | A | A | A | A |
| Adhesiveness after curing | | Strength after curing | B | B | A | A | A |
| Characteristics of cured film | | Flexibility | B | B | B | B | B |
| | | Surface tack appearance time in PCT | A | A | A | A | A |
| Degree of yellowing (UV) | | Δb after irradiation with super UV for 15 hours | B | A | A | A | A |

**Table 2**

| | | | Example 6 | Example 7 | Example 8 | Example 9 |
|---|---|---|---|---|---|---|
| A | a1 | a1-1 | | | | |
| | | a1-2 | | | | |
| | | a1-3 | 24.83 | 11.77 | 19.66 | 15.28 |
| | | a1-4 | | 11.77 | | |
| | a1' | a1'-1 | | | | |
| | a2-1 | a2-1-1 | | | | |
| | | a2-1-2 | 36.56 | 18.65 | 39.09 | 20.73 |
| | a2-2 | a2-2-1 | 18.28 | 27.87 | | |
| | | a2-2-2 | | | 39.19 | 61.92 |
| | | a2-2-3 | 18.28 | 27.87 | | |
| B | | B-1 | 0.98 | 0.99 | 0.98 | 0.98 |
| B' | | B'-1 | | | | |
| C | | C-1 | 0.69 | 0.69 | 0.69 | 0.69 |
| D | | D-1 | 0.20 | 0.20 | 0.20 | 0.20 |
| E | | E-1 | 0.20 | 0.20 | 0.20 | 0.20 |
| Total | | | 100.00 | 100.00 | 100.00 | 100.00 |
| Initial (before curing) adhesion performances | | Initial adhesion | A | B | A | B |
| | | Shear creep resistance | A | A | A | A |
| Adhesiveness after curing | | Strength after curing | A | B | A | A |
| Characteristics of cured film | | Flexibility | B | B | B | B |
| | | Surface tack appearance time in PCT | A | A | A | A |
| Degree of yellowing (UV) | | Δb after irradiation with super UV for 15 hours | A | A | A | A |

**Table 3**

| | | | Comparative Example 1 | Comparative Example 2 | Comparative Example 3 |
|---|---|---|---|---|---|
| A | a1 | a1-1 | 18.74 | 6.01 | 17.40 |
| | | a1-2 | | 6.01 | |
| | | a1-3 | | | |
| | | a1-4 | | | |
| | a1' | a1'-1 | | | |
| | a2-1 | a2-1-1 | 79.20 | | |
| | | a2-1-2 | | 85.91 | |
| | a2-2 | a2-2-1 | | | |
| | | a2-2-2 | | | |
| | | a2-2-3 | | | 80.54 |
| B | | B-1 | 0.98 | 0.98 | 0.98 |
| B' | | B'-1 | | | |
| C | | C-1 | 0.69 | 0.69 | 0.69 |
| D | | D-1 | 0.20 | 0.20 | 0.20 |
| E | | E-1 | 0.20 | 0.20 | 0.20 |
| Total | | | 100.00 | 100.00 | 100.00 |
| Initial (before curing) adhesion performances | | Initial adhesion | A | A | D |
| | | Shear creep resistance | B | D | A |
| Adhesiveness after curing | | Strength after curing | B | B | D |
| Characteristics of cured film | | Flexibility | B | B | D |
| | | Surface tack appearance time in PCT | D Tack appeared after 150 hours | B | A |
| Degree of yellowing (UV) | | Δb after irradiation with super UV for 15 hours | A | A | A |

**Table 4**

| | | | Comparative Example 4 | Comparative Example 5 | Comparative Example 6 |
|---|---|---|---|---|---|
| A | a1 | a1-1 | 21.96 | 6.26 | |
| | | a1-2 | | | |
| | | a1-3 | | | |
| | | a1-4 | | | |
| | a1' | a1'-1 | | | 8.23 |
| | a2-1 | a2-1-1 | | | 22.38 |
| | | a2-1-2 | | | |
| | a2-2 | a2-2-1 | 22.85 | | |
| | | a2-2-2 | | 91.69 | 66.85 |
| | | a2-2-3 | 53.13 | | |
| B | | B-1 | 0.98 | 0.98 | 1.46 |
| B' | | B'-1 | | | |
| C | | C-1 | 0.69 | 0.68 | 0.68 |
| D | | D-1 | 0.20 | 0.20 | 0.19 |
| E | | E-1 | 0.20 | 0.20 | 0.19 |
| Total | | | 100.00 | 100.00 | 100.00 |
| Initial (before curing) adhesion performances | | Initial adhesion | B | D | B |
| | | Shear creep resistance | A | A | A |
| Adhesiveness after curing | | Strength after curing | D | B | A |
| Characteristics of cured film | | Flexibility | D | D | B |
| | | Surface tack appearance time in PCT | A | A | A |
| Degree of yellowing (UV) | | Δb after irradiation with super UV for 15 hours | A | A | D |

As shown in Tables 1 and 2, the adhesives of Examples 1 to 9 are excellent in overall balance among initial (before curing) adhesion, adhesion after curing and characteristics of a cured film since they contain (a1) and (a2) which are constituent features of the present application. Therefore, it was demonstrated that the adhesives of Examples 1 to 9 are suited as an outdoor urethane adhesive and are particularly suited as an adhesive for solar battery backsheet.
Particularly, since the adhesives of Examples 2 to 9 contain a hydroxyphenyltriazine-based ultraviolet absorber, the degree of yellowing is rated "A" and weatherability is remarkably improved. Therefore, these adhesives are remarkably useful as a backsheet adhesive for organic-based (dye-sensitization) solar battery.

In contrast, as shown in Tables 3 and 4, the adhesives of Comparative Examples 1 to 6 are inferior in any one of initial adhesion, adhesion after curing, characteristics of a cured film and degree of yellowing since they do not contain either (a1) or (a2) as a constituent feature of the present application. Therefore, the adhesives of Comparative Examples are not suited for an outdoor urethane adhesive and thus they cannot be used for a solar battery backsheet which is exposed outdoors over a long period.
As described above, it was demonstrated that initial (before curing) adhesion, adhesion after curing and characteristics of a cured film of the urethane adhesive are improved when the polyol (a2) contains both a polyester polyol and an acrylic polyol.

### Industrial Applicability

The present invention provides an outdoor urethane adhesive. The outdoor urethane adhesive according to the present invention is used in outdoor materials such as barrier materials, roof materials, solar battery modules, window materials, outdoor flooring materials, illumination protective materials, automobile members and signboards, and is particularly suited for the production of a solar battery backsheet.

### Related Application

This application claims priority under Article 4 of the Paris Convention based on Japanese Patent Application No. 2010-292442 filed on December 28, 2010, the disclosure of which is incorporated by reference herein.

### Description of Reference Numerals

1: Solar battery module
10: Backsheet
11: Film
11a: Deposited thin film
12: Film
13: Adhesive layer
20: Sealing material (EVA)
30: Solar battery cell
40: Glass plate
50: Spacer

## Claims

1. An outdoor urethane adhesive comprising:
a urethane resin (A) obtainable by the reaction of an isocyanate compound (a1) with a polyol having an ester bond (a2), wherein
the isocyanate compound (a1) contains at least one selected from an aliphatic isocyanate and an alicyclic isocyanate, and
the polyol (a2) contains both a polyester polyol (a2-1) and an acrylic polyol (a2-2).

2. The outdoor urethane adhesive according to claim 1, wherein an alkyl group having 4 or more carbon atoms in total is connected to an ester bond in the acrylic polyol (a2-2).

3. The outdoor urethane adhesive according to claim 1 or claim 2, wherein the polyester polyol (a2-1) is obtained by the polycondensation of a dicarboxylic acid with a polyhydric akohol,
said polyhydric alcohol containing a branched aliphatic diol, and
a branched side chain in one molecule of the branched aliphatic diol containing two or more carbon atoms in total.

4. The outdoor urethane adhesive according to claim 3, wherein the branched aliphatic diol is at least one selected from 2-butyl-2-ethyl-1,3-propanediol and 2,4-diethyl-1,5-pentanediol

5. The outdoor urethane adhesive according to any one of claims 1 to 4 further comprising a hydroxyphenyltriazine-based compound (B).

6. A solar battery backsheet obtainable by using the outdoor urethane adhesive according to any one of claims 1 to 5.

7. A solar battery module obtainable by using the solar battery backsheet according to claim 6.
